# EUROPEAN PATENT APPLICATION

(11) **EP 4 513 537 A1**
(43) Date of publication of application: **26.02.2025**
(21) Application number: 22938336.9
(22) Date of filing: 19.12.2022
(51) Int. Cl.: H01L 21/687

(54) **WAFER STAGE DEVICE**

(30) Priority: 20.04.2022 CN 202210417216
(71) Applicant: Jiangsu Leuven Instruments Co., Ltd., Xuzhou, Jiangsu 221300 (CN)
(72) Inventor: SANG, Kang, Xuzhou, Jiangsu 221300 (CN); HU, Dongdong, Xuzhou, Jiangsu 221300 (CN); CHEN, Longbao, Xuzhou, Jiangsu 221300 (CN); LIU, Pengfei, Xuzhou, Jiangsu 221300 (CN); WANG, Chengyi, Xuzhou, Jiangsu 221300 (CN); CHENG, Shiran, Xuzhou, Jiangsu 221300 (CN); GUO, Song, Xuzhou, Jiangsu 221300 (CN); XU, Kaidong, Xuzhou, Jiangsu 221300 (CN)
(74) Representative: Eisenführ Speiser
(86) International application number: PCT/CN2022/139932
(87) International publication number: WO 2023/202118

(57) **Abstract**

A wafer stage device, comprising: a housing assembly communicated with an atmospheric environment, the housing assembly comprising a supporting plate; a rotating table assembly, used for supporting a wafer; a magnetic fluid shaft, comprising an inner shaft and an outer shaft, a magnetic fluid being provided between the inner shaft and the outer shaft, the outer shaft being sealedly assembled on the supporting plate, the inner shaft having a first end portion extending into the housing assembly and a second end portion extending out of the housing assembly, and the second end portion being connected to the rotating table assembly; and a driving assembly, located in the housing assembly, the driving assembly being provided with a driving shaft, the driving shaft and the inner shaft being provided in parallel, and the driving shaft being transmittingly connected to the first end portion. The wafer stage device can be conveniently assembled and maintained, has a relatively high integration level, can be relatively small in size, and can occupy less space.

## Description

The present application claims the priority of the Chinese Patent Application No. 202210417216.2, titled "WAFER STAGE DEVICE", filed on April 20, 2022 with the China National Intellectual Property Administration, which is incorporated herein by reference in its entirety.

### FIELD

The present application relates to the technical field of wafer manufacturing, and in particular to a wafer stage device.

### BACKGROUND

Ion beam etching and ion beam deposition are two common wafer processing technologies. The ion beam etching is a purely physical process, in which ions with certain energy are used to bombard a material surface to make material atoms sputter, thus achieving a purpose of etching. The ion beam deposition is a vapor deposition method, in which an ion source is used to ionize the material to be deposited, and ions are emitted to a surface of wafer under an action of an electric field to deposit a film layer, with a purpose of changing the surface properties of the workpiece.

In the process, the ion source is usually in a fixed position, and then the processing position is adjusted by rotating the wafer. The whole machining process is in a vacuum environment. For this purpose, in the conventional technology, there is a stage device for supporting the wafer, which provides a driving force to achieve the movement required for processing the wafer.

However, most of the existing stage devices use a special vacuum driving component, and the whole device is configured and exposed in vacuum environment, resulting in a high cost and inconvenient product maintenance. Moreover, occupied space of the device is large, especially in an axial direction of the wafer.

### SUMMARY

An object of the present application is to provide a wafer stage device, which can be convenient for assembly and maintenance, have a high degree of integration, can be relatively small in size and occupy less space.

In order to solve the above technical problems, there is provided a wafer stage device, including a housing assembly, a rotating platform assembly, a hydromagnetic shaft and a driving assembly. The housing assembly is in communication with the atmospheric environment and includes a supporting plate. The rotating platform assembly is configured to support the wafer. The hydromagnetic shaft includes an inner shaft and an outer shaft, and a magnetic fluid is provided between the inner shaft and the outer shaft. The outer shaft is hermetically assembled on the supporting plate. The inner shaft has a first end extending into the housing assembly and a second end extending out of the housing assembly, and the second end is connected with the rotating platform assembly. The driving assembly is located in the housing assembly, and the driving assembly is provided with a driving shaft. The driving shaft and the inner shaft are arranged in parallel with each other, and the driving shaft is in transmission connection with the first end.

By adopting this solution, the housing assembly may isolate the external vacuum environment from the internal atmospheric environment, and the driving assembly may be integrally assembled in the housing assembly. In this way, the driving assembly only needs to adopt a conventional component, so that the cost can be lower, and the assembly and maintenance can be convenient. The hydromagnetic shaft includes an inner shaft and an outer shaft rotationally sealed with each other, so that the force of the driving assembly can be transmitted to the rotating platform assembly under the condition of isolating the internal environment from external environment, and the wafer is rotated by the rotating platform assembly. The outer shaft of the hydromagnetic shaft and the driving assembly are assembled in the housing assembly, leading to a high degree of integration and a smaller volume.

Moreover, in the embodiment of the present application, the inner shaft and the driving shaft are arranged in parallel with each other, and the driving assembly may be located at a radial side of the hydromagnetic shaft, which facilitates reducing a space occupied by the stage device in an axial direction.

Optionally, the rotating platform assembly includes a supporting platform and a clamping part. The clamping part is used to press the wafer against the supporting platform.

Optionally, the rotating platform assembly further includes a rotating main body. The rotating main body includes the clamping part, a force transmission member and a guide rod. The clamping part and the force transmission member are located at two axial sides of the supporting platform, respectively. The guide rod passes through the supporting platform, and both ends of the guide rod are respectively connected with the clamping part and the force transmission member.

Optionally, the force transmission member includes an inner fixing member, an outer fixing member and a bearing. The outer fixing member is connected with an outer ring of the bearing, and the inner fixing member is connected with an inner ring of the bearing. One of the guide rod and the lifter is connected with the inner fixing member, and the other is connected with the outer fixing member.

Optionally, the inner fixing member includes an inner cylindrical part and a first stop part. The first stop part is mounted to the inner cylindrical part, or the first stop part and the inner cylindrical part have a one-piece structure. The inner ring is mounted outside the inner cylindrical part, and the first stop part is used to axially stop an axial end of the inner ring.

Optionally, the outer fixing member includes an outer cylindrical part and a second stop part. The second stop part is mounted to the outer cylindrical part, or the second stop part and the outer cylindrical part are in a one-piece structure. The outer cylindrical part is mounted outside the outer ring, and the second stop part is used to axially stop the outer ring.

Optionally, the inner fixing member further includes an inner baffle, and the inner baffle is fixed to the inner cylindrical part and used to axially stop the other axial end of the inner ring.

Optionally, the rotating main body further includes a guide sleeve. The guide sleeve is mounted on the supporting platform, and the guide rod is inserted into the guide sleeve.

Optionally, the wafer stage device further includes a lifting assembly. The lifting assembly includes a main body and a lifter. The main body is located in the housing assembly. The lifter is slidably sealed with the supporting plate or the outer shaft, and the lifter may interact with the force transmission member.

Optionally, the lifter and the force transmission member are fixedly connected with each other.

Optionally, the main body further includes a pneumatic cylinder and a lifting plate. The pneumatic cylinder is provided with a piston rod which is connected with the lifting plate, and multiple lifting bodies are mounted on the lifting plate.

Optionally, both axial ends of the bellows are provided with mounting seats respectively.

Optionally, the main body includes a bellows. The bellows is mounted outside the lifter.

Optionally, the wafer stage device further includes a dust cover. The dust cover is mounted on the supporting platform and connected with the housing assembly.

Optionally, the wafer stage device further includes a rotating joint. The rotating joint is mounted to the inner shaft.

Optionally, the wafer stage device further includes a slip ring. The slip ring is mounted to the inner shaft.

Optionally, the housing assembly further includes a first housing. The first housing is hermetically mounted on the supporting plate and, together with the supporting plate, defines a first space.

Optionally, the housing assembly further includes a second housing. The first housing is provided with a first notch. The second housing is hermetically mounted to the first housing and may cover the first notch. The second housing and the first housing define a second space, and the slip ring may extend into the second space from the first notch.

Optionally, the housing assembly further includes a third housing. The supporting plate is provided with a second notch. The third housing is hermetically mounted on the supporting plate and may cover the second notch. The third housing and the supporting plate define a third space, and the driving assembly is mounted on the supporting plate and partially extends into the third space.

Optionally, the wafer stage device further includes a cylindrical revolving shaft. The revolving shaft is mounted on the third housing and is communicated with the third space.

### BRIEF DESCRIPTION OF THE DRAWINGS

FIG. 1 is a schematic structural view of a specific embodiment of a wafer stage device provided according to the present application;
FIG. 2 is a structural view of the wafer stage device shown in FIG. 1 which is mounted in a vacuum chamber;
FIG. 3 is a schematic structural view of a rotating main body;
FIG. 4 is a sectional view of a force transmission member;
FIG. 5 is a schematic structural view of a lifting assembly;
FIG. 6 is a structural view showing connection between a lifter, a hydromagnetic shaft and a force transmission member; and
FIG. 7 is a schematic structural view of a driving assembly.

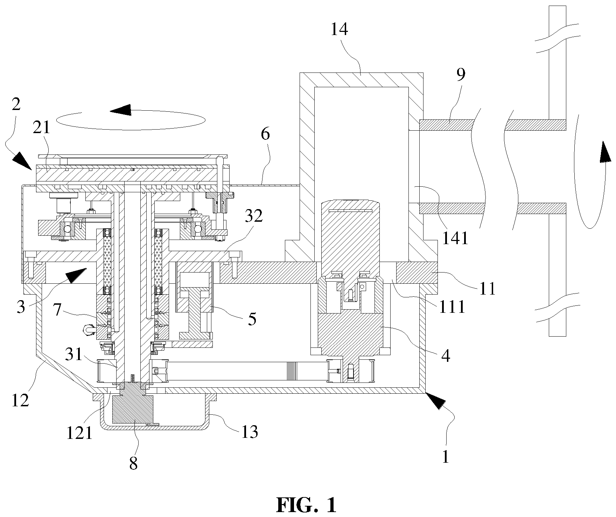

Description of the reference numerals in FIGS. 1 to 7:
1 housing assembly, 11 supporting plate, 111 second notch, 12 first housing, 121 first notch, 13 second housing, 14 third housing, 141 third notch;
2 rotating platform assembly, 21 supporting platform, 22 rotating main body, 221 clamping part, 222 force transmission member, 222a inner fixing member, 222a-1 inner cylindrical part, 222a-2 first stop part, 222a-3 inner baffle, 222b outer fixing member, 222b-1 outer cylindrical part, 222b-2 second stop part, 222c bearing, 223 guide rod, 224 guide sleeve;
3 hydromagnetic shaft, 31 inner shaft, 32 outer shaft, 33 magnetic fluid;
4 driving assembly, 41 motor, 42 speed reducer, 43 fixing plate, 44 driving wheel, 45 driven wheel, 46 synchronous belt;
5 lifting assembly, 51 main body, 511 cylinder body, 512 sensor, 513 lifting plate, 514 bellows, 515 first mounting seat, 516 second mounting seat, 52 lifter;
6 dust cover;
7 rotating joint;
8 slip ring;
9 revolving shaft;
10 vacuum chamber;
A first space, B second space, C third space, D first vacuum space, E second vacuum space.

### DETAILED DESCRIPTION OF THE EMBODIMENTS

Hereinafter, in order to enable those skilled in the art to better understand the technical solutions of the present application, the present application will be described in further detail with reference to the accompanying drawings in conjunction with specific embodiments.

In the specification, the term "multiple" refers to a plural indefinite number or quantity, usually more than two. When the term "multiple" is used to indicate the number of certain components, it does not mean that these components are quantitatively related to each other.

Herein, the terms such as "first" and "second" are only intended to distinguish two or more structures or components that have identical or similar structure and/or functions, and do not indicate any special limitation on an order and/or importance.

Magnetic fluid, also known as magnetic liquid or ferrofluid, is a colloidal material composed of solid and liquid phases. The solid phase mainly refers to magnetic solid nanoparticles, and the liquid phase refers to the liquid that can carry the solid magnetic nanoparticles. The magnetic fluid has the fluidity, lubricity and sealing performance of liquid carriers, and also has the strong magnetism and other characteristics of solid nanoparticles.

Hydromagnetic sealing is to fix the magnetic fluid between an inner shaft and an outer shaft with permanent magnets. Since a gap between the inner shaft and the outer shaft is very small and its magnetic field strength is particularly large, it can bear a large thrust along a direction of an axis to achieve the sealing effect. The inner shaft, the outer shaft and the magnetic fluid provided therebetween can be collectively called the hydromagnetic shaft.

As mentioned in the background, most of the driving components used in the existing stage device are vacuum driving components. The whole stage device is assembled and exposed to a vacuum environment, which results in high costs, is unfavorable for product assembly and maintenance, and occupy a large space.

In view of the above, a wafer stage device is provided according to an embodiment of the present application, which isolates an internal space (atmospheric environment) from an external space (vacuum environment) of the housing assembly by providing the housing assembly. A driving assembly may be arranged in the housing assembly, that is, the driving assembly may be located in the atmospheric environment. In this way, the driving assembly only needs to adopt a conventional component, resulting in lower costs and reduced difficulty in assembly and maintenance.

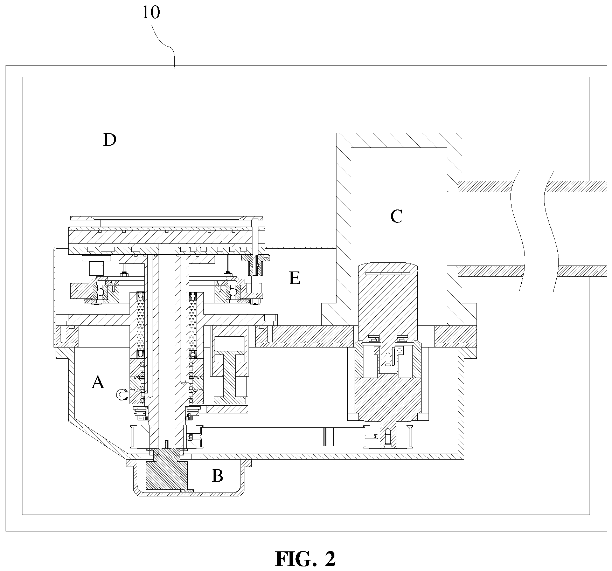

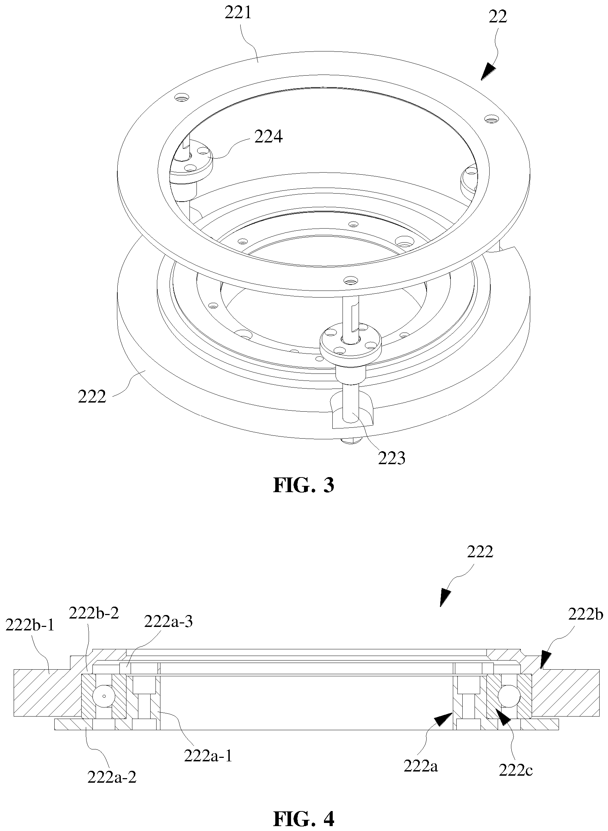

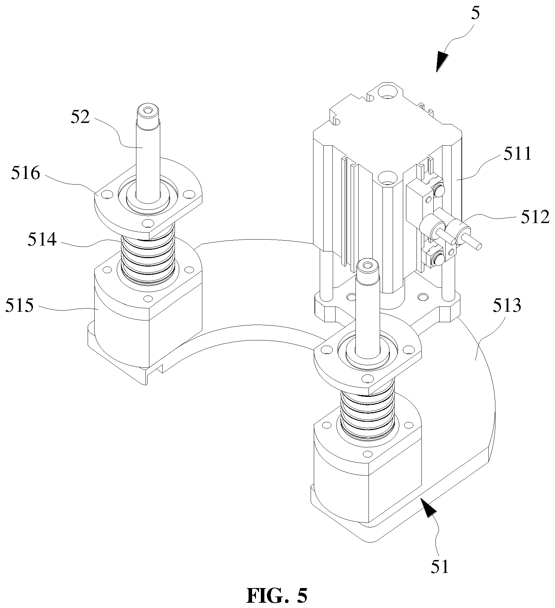

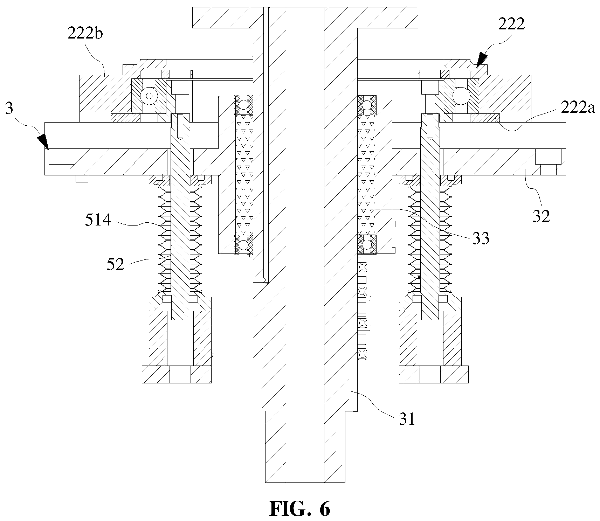

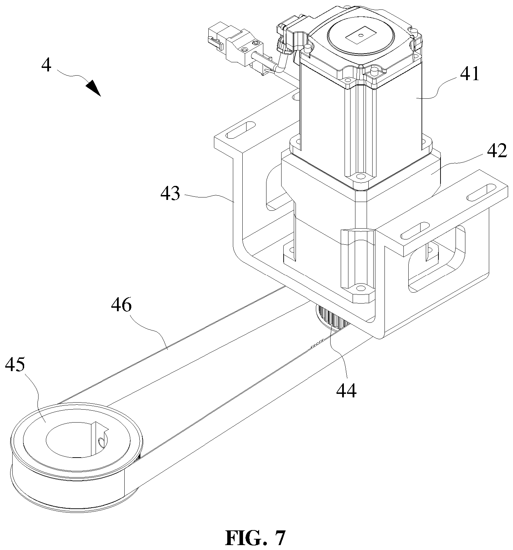

Reference may be made to FIGS. 1 to 7. FIG. 1 is a schematic structural view of a specific embodiment of a wafer stage device provided according to the present application. FIG. 2 is a structural view of the wafer stage device in FIG. 1 which is mounted in a vacuum chamber. FIG. 3 is a schematic structural view of a rotating main body. FIG. 4 is a sectional view of a force transmission member. FIG. 5 is a schematic structural view of a lifting assembly. FIG. 6 is a structural view showing connection between a lifter, a hydromagnetic shaft and a force transmission member. FIG. 7 is a schematic structural view of a driving assembly.

As shown in FIGS. 1 and 2, a wafer stage device is provided according to the present application, including a housing assembly 1, a rotating platform assembly 2, a hydromagnetic shaft 3 and a driving assembly 4. An internal space of the housing assembly 1 is communicated with the atmospheric environment, that is, the internal space of the housing assembly 1 is the atmospheric environment, and the housing assembly 1 includes a supporting plate 11. The rotating platform assembly 2 is used to support a wafer. The hydromagnetic shaft 3 includes an inner shaft 31 and an outer shaft 32, which may rotate relative to each other. A magnetic fluid 33 is arranged between the inner shaft 31 and the outer shaft 32 to realize the sealing between the inner shaft 31 and the outer shaft 32. The outer shaft 32, serving as a fixed shaft, is assembled on the supporting plate 11 in a sealed manner (for example, by providing a sealing ring, a gasket or the like),. The inner shaft 31 has a first end extending into the housing assembly 1 and a second end extending out of the housing assembly 1. The second end is connected with the rotating platform assembly 2. The driving assembly 4 is located in the housing assembly 1, and the driving assembly 4 has a driving shaft (not shown). The driving shaft is arranged in parallel with the inner shaft 31 and is in transmission connection with the first end so as to drive the inner shaft 31 to rotate.

By adopting the above solution, the housing assembly 1 may isolate the external vacuum environment from the internal atmospheric environment, and the driving assembly 4 may be integrally assembled in the housing assembly 1. In this way, the driving assembly 4 only needs to adopt a conventional component, so that the cost can be lower, and the assembly and maintenance can be convenient. The hydromagnetic shaft 3 includes the inner shaft 31 and the outer shaft 32 rotationally sealed with each other, and may transmit the force of the driving assembly 4 to the rotating platform assembly 2 under the condition of isolating the internal environment from external environment, so as to drive the wafer to rotate by the rotating platform assembly 2. The outer shaft 32 of the hydromagnetic shaft 3 and the driving assembly 4 are both assembled in the housing assembly 1, leading to a high degree of integration and a smaller volume.

Moreover, in the embodiment of the present application, the inner shaft 31 and the driving shaft are arranged in parallel to each other, and the driving assembly 4 may be located at a radial side of the hydromagnetic shaft 3, which facilitates reducing the occupied space of the stage device in the axial direction.

Here, the embodiment of the present application does not limit the specific structures of the housing assembly 1, the rotating platform assembly 2 and the driving assembly 4. In practice, those skilled in the art may design based on actual needs, as long as it can meet the use requirements. The structures of the above components will be illustrated in the following embodiments of the present application.

The rotating platform assembly 2 is used to support the wafer so as to facilitate processing the wafer. The processing technologies include but not limited to ion beam etching and ion beam deposition mentioned in the background. With reference to FIGS. 1 and 3, in the embodiment shown, the rotating platform assembly 2 may include a supporting platform 21 and a clamping part 221. The supporting platform 21 is used to directly support the wafer, and the clamping part 221 is used to press the wafer to reliably fix the wafer. The clamping part 221 may be a one-piece annular part, or may include multiple split parts distributed in the circumferential direction.

The rotating platform assembly 2 may further include a rotating main body 22, which may include the clamping part 221 described above, a force transmission member 222 and a guide rod 223. The clamping part 221 and the force transmission member 222 may be located at two axial sides of the supporting platform 21, respectively. The guide rod 223 may be slidably assembled on the supporting platform 21, that is, the guide rod 223 may slide relative to the supporting platform 21. Both ends of the guide rod 223 may be connected with the clamping part 221 and the force transmission member 222, respectively, enabling the rotating main body 22 and the supporting platform 21 to form an integral component and improving the integration level.

The supporting platform 21 may be provided with a through hole (not shown), and the guide rod 223 may be inserted into the through hole, so as to realize the sliding of the guide rod 223 relative to the supporting platform 21.

On this basis, the rotating main body 22 may further include a guide sleeve 224. The guide sleeve 224 may be mounted on the supporting platform 21, specifically, on the axial side of the supporting platform 21 or in the supporting platform 21. The guide rod 223 may also be inserted into the guide sleeve 224. The guide sleeve 224 is a special guide fitting, which has higher guide precision and is more conducive to ensuring the sliding direction of the guide rod 223. It can be understood that the guide sleeve 224 may not be provided, and in this case, the guide rod 223 may be guided by the through hole.

Further, the wafer stage device may include a lifting assembly 5. The lifting assembly 5 includes a main body 51 and a lifter 52. The main body 51 may also be located in the housing assembly 1, in which case the lifting assembly 5 is basically located in the atmospheric environment and can adopt a conventional component to facilitate assembly and maintenance. The lifter 52 may be slidably sealed with the supporting plate 11 or the outer shaft 32, so as not to affect the isolation between the atmospheric environment and the vacuum environment, and the lifter 52 may be connected with the force transmission member 222, so as to drive the rotating main body 22 to move upwards or downwards.

Under the action of the main body 51, the lifter 52 may drive the clamping part 221 to move upwards or downwards via the force transmission member 222 and the guide rod 223. When the clamping part 221 moves relatively away from the supporting platform 21, the wafer is easily placed, and when the clamping part 221 moves relatively close to the supporting platform 21, the wafer can be tightly pressed.

It should be pointed out that the clamping part 221 may clamp and fix the wafer by its own gravity or by the force coming from the lifting assembly 5, which depends on the connection mode between the lifter 52 and the force transmission member 222. When the lifter 52 is fixedly connected with the force transmission member 222 (the connection mode is not limited), the clamping part 221 may clamp the wafer under the action of the lifting assembly 5. When the lifter 52 abuts against the force transmission member 222, that is, when the lifter 52 can only apply an upward jacking force but cannot apply a downward pulling force to the clamping part 221, the clamping part 221 may clamp the wafer under its own gravity.

Take the fixed connection between the lifter 52 and the force transmission member 222 as an example. With reference to FIG. 4, the force transmission member 222 may include an inner fixing member 222a, an outer fixing member 222b and a bearing 222c. The outer fixing member 222b is connected with an outer ring of the bearing 222c, and the inner fixing member 222a is connected with an inner ring of the bearing 222c. Under the action of the bearing 222c, the outer fixing member 222b and the inner fixing member 222a may rotate relative to each other. One of the guide rod 223 and the lifter 52 may be connected with the inner fixing member 222a, and the other may be connected with the outer fixing member 222b, so as to overcome the problem of rotation interference between the lifter 52 and the guide rod 223. The following embodiments of the present application will be exemplarily described, in which the guide rod 223 is connected with the outer fixing member 222b and the lifter 52 is connected with the inner fixing member 222a.

The inner fixing member 222a and the outer fixing member 222b may have various structural forms, as long as the connection reliability between the inner fixing member 222a, the outer fixing member 222b and the bearing 222c can be ensured. In some alternative embodiments, as shown in FIG. 4, the inner fixing member 222a may include an inner cylindrical part 222a-1 and a first stop part 222a-2. The first stop part 222a-2 may be mounted to the inner cylindrical part 222a-1, or the first stop part 222a-2 and the inner cylindrical part 222a-1 may be of a one-piece structure. The inner ring of the bearing 222c may be mounted outside the inner cylindrical part 222a-1, and the first stop part 222a-2 may be used to axially stop an axial end (the lower end in FIG. 4) of the inner ring. The outer fixing member 222b may include an outer cylindrical part 222b-1 and a second stop part 222b-2. The second stop part 222b-2 may be mounted to the outer cylindrical part 222b-1, or the second stop part 222b-2 and the outer cylindrical part 222b-1 may be of a one-piece structure. The outer cylindrical part 222b-1 may be mounted outside the outer ring of the bearing 222c, and the second stop part 222b-2 may be used to axially stop the outer ring. In this way, the bearing 222c can be stably mounted and fixed.

Further, the inner fixing member 222a may further include an inner baffle 222a-3. The inner baffle 222a-3 may be fixed to the inner cylindrical part 222a-1, for example, by screw connection, snap-fit, riveting, welding, etc., so as to axially stop the other axial end of the inner ring of the bearing 222c. With reference to FIG. 4, the inner baffle 222a-3 may be located at an inner side of the second stop part 222b-2, and the mounting structure is compact.

Here, the embodiment of the present application is not intended to limit the specific structural form of the lifting assembly 5. In practical application, the skilled in the art can make a choice as required. For example, the lifting assembly 5 may adopt a driving element that can directly output linear displacement, for example, a pneumatic cylinder or a hydraulic cylinder. In this case, the lifter 52 described above may be a piston rod of such a driving element. Alternatively, the lifting assembly 5 may also use a driving element that can directly output rotational displacement, for example, a motor. In this case, it is necessary to provide a displacement conversion mechanism in the form of a rack-and-pinion mechanism, a lead screw mechanism or the like to convert the directly output rotational displacement into the required linear displacement. Taking the rack-and-pinion mechanism as an example, the lifter 52 described above may be a rack.

In the embodiment shown in FIG. 5, the lifting assembly 5 may adopt a standard pneumatic cylinder. The main body 51 may include a cylinder body 511, a piston rod (not labeled in the figure) and a lifting plate 513. The piston rod may be extendable and retractable in the cylinder body 511 to drive the lifting plate 513 to move upwards or downwards. The lifter 52 described above may be mounted on the lifting plate 513. With this structure, the lifting plate 513 is equivalent to a transition connector, on which multiple lifters 52 (two lifters 52 shown in the drawing) can be mounted, and then multi-point driving can be realized by a single pneumatic cylinder. Thus, on the one hand, the number of the pneumatic cylinders can be reduced to save costs, and the problem of inconsistent actions caused by the use of multiple pneumatic cylinders can be avoided. On the other hand, the multi-point driving is more conducive to ensuring the stability of the raising and lowering of the force transmission member 222.

The cylinder body 511 is further provided with a sensor 512 for monitoring the stroke of the pneumatic cylinder 511 so as to control the pneumatic cylinder 511.

With reference to FIG. 5 and in conjunction with FIG. 6, the main body 51 may further include a first mounting seat 515 and a second mounting seat 516. The first mounting seat 515 may be mounted on the lifting plate 513. The lifter 52 may be mounted on the first mounting seat 515. The second mounting seat 516 may be arranged outside the lifter 52, and the second mounting seat 516 may be fixedly connected with the outer shaft 32.

Further, a bellows 514 may be provided, and may be arranged outside the lifter 52. One end of the bellows 514 may be connected with the second mounting seat 516, and the other end may be connected with the first mounting seat 515. The bellows 514 may be used to isolate the vacuum environment from the atmospheric environment. Moreover, the bellows 514 has certain elastic deformation ability. When the pneumatic cylinder is inflated to drive the rotating main body 22 to move upwards, the bellows 514 may be compressed. When the pneumatic cylinder is deflated, the elastic force of the bellows 514 may be released to drive the clamping part 221 to quickly return. Moreover, the bellows 514 may be further configured to limit the stroke of the pneumatic cylinder 511.

It can be understood that the means for achieving the sliding sealing is not limited to the bellows 514, but can also be realized by providing an annular sealing member such as a sealing ring.

The driving assembly 4 may specifically adopt a motor 41, and a rotating shaft of the motor 41 may be directly connected with the inner shaft 31 in a rotating manner. In this case, the rotating shaft of the motor 41 is a driving shaft. Alternatively, as shown in FIG. 7, the driving assembly 4 may further include a speed reducer 42 to adjust the transmission ratio, in which case the output shaft of the speed reducer 42 is the driving shaft. The driving assembly 4 may be mounted on the supporting platform 21 via a fixing plate 43. Thus, in the wafer stage device provided by the present application, the hydromagnetic shaft 3, the driving assembly 4 and the lifting assembly 5 are all mounted to the supporting platform 21, thus greatly improving the compactness.

The means for achieving the transmission connection between the driving shaft and the inner shaft 31 include but are not limited to gears, sprockets and pulleys. In the embodiment shown in FIG. 7, a pulley is adopted for the transmission connection between the driving shaft and the inner shaft 31. A driving wheel 44 may be mounted on the driving shaft, and a driven wheel 45 may be mounted on the inner shaft 31, and a synchronous belt 46 may be mounted on the driving wheel 44 and the driven wheel 45.

The wafer stage device provided by the present application may further include a rotating joint 7, which is mounted on the inner shaft 31. Helium, coolant and the like may be delivered to the inner shaft 31 through the rotating joint 7. Further, the wafer stage device may also include a slip ring 8, which may be mounted to the inner shaft 31 for channeling cables such as electric wires and signal lines.

Still as shown in FIG. 1 and with reference to FIG. 2, the housing assembly 1 may further include a first housing 12 and a second housing 13. The first housing 12 may be mounted on the supporting plate 11 in a sealed manner (for example, by providing a sealing ring, a gasket or the like), and the first housing 12 and the supporting plate 11 may define a first space A. The first housing 12 may be provided with a first notch 121, and the second housing 13 may be hermetically mounted to the first housing 12 and may cover the first notch 121. The second housing 13 and the first housing 12 may define a second space B, and the slip ring 8 may extend into the second space B from the first notch 121. In this way, when the slip ring 8 and its adjacent parts need to be overhauled or replaced, the second housing 13 may be removed without disassembling the first housing 12. Thus, the overhaul and maintenance of the device is convenient.

Further, the housing assembly 1 may include a third housing 14. The supporting plate 11 may be provided with a second notch 111. The third housing 14 may be mounted on the supporting plate 11 in a sealed manner (for example, by providing a sealing ring, a gasket or the like) and may cover the second notch 111. The third housing 14 and the supporting plate 11 may define a third space C. The driving assembly 4 may be mounted on the supporting plate 11 and may partially extend into the third space C. With reference to FIG. 7, the motor 41 in the driving assembly 4 may specifically extend into the third space C.

Further, a cylindrical revolving shaft 9 may be provided, and the revolving shaft 9 may be mounted on the third housing 14. The third housing 14 may be provided with a third notch 141, through which the internal space of the revolving shaft 9 may communicate with the third space C. The form of the driving structure to which the revolving shaft 9 is connected is not limited here. In practice, the revolving shaft 9 may be rotated firstly to adjust the orientation of the stage device. The lifting assembly 5 is then controlled to move upward and downward to load and clamp the wafer, and then the supporting platform 21 is controlled by the driving assembly 4 to rotate.

With reference to FIG. 2, in the vacuum chamber 10, a first space A, a second space B and a third space C are isolated by the housing assembly 1. Each of these three spaces may be communicated with the external environment through the revolving shaft, thus forming the atmospheric environment. The hydromagnetic shaft 3, the driving assembly 4, the lifting assembly 5, the rotating joint 7 and the slip ring 8 of the stage device are basically located in the atmospheric environment, and only the rotating platform assembly 2 in the stage device is located in the vacuum environment.

Further, a dust cover 6 may be provided. The dust cover 6 may be mounted to the supporting platform 21 and connected with the housing assembly 1, so as to reduce the possibility of dust falling into the force transmission member 222 and the hydromagnetic shaft 3. The dust cover 6 divides the vacuum environment into a first vacuum space D and a second vacuum space E.

The above descriptions are merely preferred embodiments of the present application. It should be noted that various improvements and modifications can be made by those skilled in the art without departing from the principles of the present application. These improvements and modifications should fall within the protection scope of the present application.

## Claims

1. A wafer stage device, comprising:
a housing assembly (1) communicated with atmospheric environment and comprising a supporting plate (11);
a rotating platform assembly (2) configured to support a wafer;
a hydromagnetic shaft (3) comprising an inner shaft (31) and an outer shaft (32), wherein a magnetic fluid (33) is arranged between the inner shaft (31) and the outer shaft (32), the outer shaft (32) is hermetically assembled on the supporting plate (11), the inner shaft (31) has a first end extending into the housing assembly (1) and a second end extending out of the housing assembly (1), and the second end is connected with the rotating platform assembly (2); and
a driving assembly (4) located in the housing assembly (1) and having a driving shaft, wherein the driving shaft is arranged in parallel with the inner shaft (31) and is drivingly connected to the first end.

2. The wafer stage device according to claim 1, wherein the rotating platform assembly (2) comprises a supporting platform (21) and a clamping part (221), and the clamping part (221) is configured to press the wafer against the supporting platform (21).

3. The wafer stage device according to claim 2, wherein the rotating platform assembly (2) further comprises a rotating main body (22), and the rotating main body (22) comprises the clamping part (221), a force transmission member (222) and a guide rod (223), wherein the clamping part (221) and the force transmission member (222) are located at two axial sides of the supporting platform (21) respectively, the guide rod (223) passes through the supporting platform (21), and both ends of the guide rod (223) are respectively connected with the clamping part (221) and the force transmission member (222).

4. The wafer stage device according to claim 3, wherein the force transmission member (222) comprises an inner fixing member (222a), an outer fixing member (222b) and a bearing (222c), wherein the outer fixing member (222b) is connected with an outer ring of the bearing (222c), and the inner fixing member (222a) is connected with an inner ring of the bearing (222c); and
one of the guide rod (223) and the lifter (52) is connected with the inner fixing member (222a), and the other of the guide rod (223) and the lifter (52) is connected with the outer fixing member (222b).

5. The wafer stage device according to claim 4, wherein the inner fixing member (222a) comprises an inner cylindrical part (222a-1) and a first stop part (222a-2), wherein the first stop part (222a-2) is mounted to the inner cylindrical part (222a-1), or the first stop part (222a-2) and the inner cylindrical part (222a-1) are of a one-piece structure, and wherein the inner ring is mounted outside the inner cylindrical part (222a-1), and the first stop part (222a-2) is configured to axially stop an axial end of the inner ring.

6. The wafer stage device according to claim 4, wherein the outer fixing member (222b) comprises an outer cylindrical part (222b-1) and a second stop part (222b-2), wherein the second stop part (222b-2) is mounted to the outer cylindrical part (222b-1), or the second stop part (222b-2) and the outer cylindrical part (222b-1) are of a one-piece structure, and wherein the outer cylindrical part (222b-1) is mounted outside the outer ring, and the second stop part (222b-2) is configured to axially stop the outer ring.

7. The wafer stage device according to claim 5, wherein the inner fixing member (222a) further comprises an inner baffle (222a-3), and the inner baffle (222a-3) is fixed to the inner cylindrical part (222a-1) and configured to axially stop the other axial end of the inner ring.

8. The wafer stage device according to claim 3, wherein the rotating main body (22) further comprises a guide sleeve (224), wherein the guide sleeve (224) is mounted on the supporting platform (21), and the guide rod (223) is inserted into the guide sleeve (224).

9. The wafer stage device according to claim 3, further comprising a lifting assembly (5), wherein the lifting assembly (5) comprises a main body (51) and a lifter (52), wherein the main body (51) is located in the housing assembly (1), the lifter (52) is slidably sealed with the supporting plate (11) or the outer shaft (32), and the lifter (52) is adapted to interact with the force transmission member (222).

10. The wafer stage device according to claim 9, wherein the lifter (52) and the force transmission member (222) are fixedly connected with each other.

11. The wafer stage device according to claim 9, wherein the main body (51) comprises a bellows (514), and the bellows (514) is mounted outside the lifter (52).

12. The wafer stage device according to claim 11, wherein each of both axial ends of the bellows (514) is provided with a mounting seat.

13. The wafer stage device according to claim 9, wherein the main body (51) further comprises a pneumatic cylinder and a lifting plate (513), wherein the pneumatic cylinder is provided with a piston rod connected with the lifting plate (513), and a plurality of lifting bodies (52) are mounted on the lifting plate (513).

14. The wafer stage device according to claim 2, further comprising a dust cover (6), wherein the dust cover (6) is mounted to the supporting platform (21) and connected with the housing assembly (1).

15. The wafer stage device according to any one of claims 1 to 14, further comprising a rotating joint (7), wherein the rotating joint (7) is mounted to the inner shaft (31).

16. The wafer stage device according to any one of claims 1 to 14, further comprising a slip ring (8), wherein the slip ring (8) is mounted to the inner shaft (31).

17. The wafer stage device according to claim 16, wherein the housing assembly (1) further comprises a first housing (12), and the first housing (12) is hermetically mounted on the supporting plate (11) and, together with the supporting plate (11), defines a first space (A).

18. The wafer stage device according to claim 17, wherein the housing assembly (1) further comprises a second housing (13), and the first housing (12) is provided with a first notch (121), wherein the second housing (13) is hermetically mounted to the first housing (12) and covers the first notch (121), the second housing (13) and the first housing (12) define a second space (B), and the slip ring (8) extends into the second space (B) from the first notch (121).

19. The wafer stage device according to any one of claims 1 to 14, wherein the housing assembly (1) further comprises a third housing (14), and the supporting plate (11) is provided with a second notch (111), wherein the third housing (14) is hermetically mounted on the supporting plate (11) and covers the second notch (111), the third housing (14) and the supporting plate (11) define a third space (C), and the driving assembly (4) is mounted on the supporting plate (11) and partially extends into the third space (C).

20. The wafer stage device according to claim 19, further comprising a cylindrical revolving shaft (9), wherein the revolving shaft (9) is mounted to the third housing (14) and communicates with the third space (C).
